# FASCICULE DE BREVET EUROPEEN

(11) **EP 2 963 235 B1**
(45) Date de publication et mention de la délivrance du brevet: **22.02.2017**
(21) Numéro de dépôt: 15305934.0
(22) Date de dépôt: 16.06.2015
(51) Int. Cl.: E21B 43/30

(54) **PROCEDE D'EXPLOITATION D'UN GISEMENT PETROLIER A PARTIR D'UNE TECHNIQUE DE POSITIONNEMENT DES PUITS A FORER**
AUSBEUTUNGSVERFAHREN EINES ERDÖLLAGERS MITHILFE EINER POSITIONIERTECHNIK VON BOHRBRUNNEN
METHOD FOR EXPLOITING AN OIL DEPOSIT BASED ON A TECHNIQUE FOR POSITIONING WELLS TO BE DRILLED

(30) Priorité: 04.07.2014 FR 1456465
(43) Date de publication de la demande: 06.01.2016
(73) Titulaire: IFP Énergies nouvelles, 92852 Rueil-Malmaison Cedex (FR)
(72) Inventeur: FORNEL, Alexandre, 92500 RUEIL MALMAISON (FR); LE RAVALEC, Mickaele, 92500 RUEIL-MALMAISON (FR)

(56) Documents cités:
- EP-A1- 2 628 893
- US-A1- 2013 020 131
- MICKAELE LE RAVALEC: "Optimizing Well Placement With Quality Maps Derived From Multi-fidelity Meta-models", EAGE ANNUAL CONFERENCE & EXHIBITION INCORPORATING SPE EUROPE, SPE, no. SPE 154416, 4 juin 2012 (2012-06-04), pages 1-10, XP007921320,
- CAVALCANTE J S DE A: "Methodology for Quality Map Generation to Assist with the Selection and Refinement of Production Strategies", SPE INTERNATIONAL OIL AND GAS CONFERENCE AND EXHIBITION, XX, XX, no. SPE 101940-STU, 9 octobre 2005 (2005-10-09), pages 1-10, XP002676803,
- Akram Habil ET AL: "SPE 127344 Collaborative Well Planning and Optimization of Well Placement: A Case Study From Mangala Field Development, Rajasthan India", , 20 janvier 2010 (2010-01-20), pages 20-22, XP055185105, Extrait de l'Internet: URL:http://www.spe.org/ [extrait le 2015-04-22]

## Description

La présente invention concerne le domaine technique de l'industrie pétrolière, et plus particulièrement l'exploitation de gisements pétroliers.

En particulier, l'invention permet de planifier efficacement le développement d'un gisement en sélectionnant les positions de forage de nouveaux puits et l'ordre selon lequel forer ces nouveaux puits.

L'optimisation et l'exploitation des gisements pétroliers reposent sur une description aussi précise que possible de la structure, des propriétés pétrophysiques, des propriétés des fluides, etc., du gisement étudié. Pour ce faire, les spécialistes utilisent une maquette du sous-sol qui permet de rendre compte de ces aspects de façon approchée : le modèle de réservoir. Généralement, ce type de maquette est représenté sur un ordinateur, et l'on parle alors de modèle numérique. Un modèle de réservoir comporte un maillage ou grille, généralement tridimensionnelle, associée à une ou plusieurs cartes de propriétés pétrophysiques (porosité, perméabilité, saturation...). L'association consiste à attribuer des valeurs de ces propriétés pétrophysiques à chacune des mailles de la grille.

Un modèle de réservoir se doit de vérifier autant que possible l'ensemble des données collectées sur le terrain : les données de diagraphie mesurées le long des puits, les mesures réalisées sur des échantillons de roche prélevés dans les puits, les données déduites de campagnes d'acquisition sismique, les données de production comme les débits d'huile, d'eau, les variations de pression etc. Ces données étant insuffisantes pour parvenir à définir de façon exacte les valeurs des propriétés pétrophysiques à attribuer à chacune des mailles du modèle, on a recourt d'ordinaire à un formalisme stochastique. Pour ce type de formalisme, les propriétés pétrophysiques sont considérées comme des réalisations de fonctions aléatoires. On génère alors une image possible du réservoir, c'est-à-dire un modèle, à partir de techniques géostatistiques de simulation. La résolution des équations d'écoulement pour ce modèle, obtenue via une simulation d'écoulement, dite aussi simulation de réservoir, fournit des réponses en production. Ces réponses sont alors comparées aux données de production mesurées dans les puits. Pour accroître la prédictibilité du modèle de réservoir, il faut alors minimiser l'écart entre les réponses simulées et les données acquises sur le terrain. Cette étape, connue sous le terme de calage, est réalisée par un processus d'optimisation. Ce dernier est en général très coûteux en temps calcul, car il est itératif et nécessite une simulation d'écoulement par itération. Or, une unique simulation d'écoulement implique souvent plusieurs heures de temps calcul sur un ordinateur.

Lorsqu'un modèle respectant l'ensemble des données mesurées sur le terrain est finalement obtenu, il est utilisé pour prédire les déplacements de fluide dans le réservoir et planifier le développement futur du gisement. Par exemple, pour les champs matures, il faut pouvoir sélectionner les zones où forer de nouveaux puits, soit pour produire l'huile par déplétion, soit pour injecter un fluide qui maintient la pression à un niveau suffisant dans le réservoir. Pour apprécier la performance d'un puits en un point, on peut s'appuyer sur le modèle de réservoir, y positionner le puits à la position souhaitée et exécuter une simulation de réservoir. La performance d'un puits s'apprécie à partir de la quantité d'hydrocarbures qu'il produit. L'objectif final étant de maximiser la production ou la rentabilité du champ, il faudrait pouvoir tester toutes les positions possibles et ainsi sélectionner la meilleure d'entre elles. Une telle approche est inappropriée en pratique, car trop consommatrice en temps de calcul. Une alternative consiste à lancer un processus d'optimisation visant à rechercher la position du puits permettant d'optimiser la production du gisement étudié. Toutefois, cette démarche est également délicate à mettre en oeuvre, car elle nécessite des milliers d'itérations et donc des milliers de simulations de réservoir.

Le concept de carte d'indicateurs de production, également appelée dans la littérature carte de qualité, a été introduit pour répondre de façon pratique au problème du placement de nouveaux puits dans un réservoir. Il s'agit d'une carte bidimensionnelle, comprenant un ensemble de mailles, où chaque maille est associée à une valeur réelle qui montre comment un nouveau puits placé dans la maille en question impacte la production ou la valeur actuelle nette (VAN) par rapport au cas de base. Un indicateur de production définit un impact sur la production du fluide (hydrocarbure) lié à l'ajout d'un puits dans la maille considérée.

Pour construire cette carte, on peut faire une simulation d'écoulement pour chaque maille où il est possible de placer un puits. Si le réservoir comprend NX et NY mailles suivant les axes X et Y, le nombre total de mailles à examiner est de NXxNY auquel on soustrait les nombres de mailles non actives et de mailles dans lesquelles on a déjà un puits pour le cas de base. Cette approche nécessite un temps de calcul significatif dès que NXxNY est important. En outre, les mailles possibles étant considérées les unes après les autres, les interférences entre les nouveaux puits ne sont pas prises en compte.

Une alternative, proposée par la demanderesse dans la demande EP 2568110 (US 2013/0020131) repose sur la construction de carte d'indicateurs de production déterminés par interpolation, la méthode d'interpolation choisie étant dépendante de la distance entre la maille considérée et le puits le plus proche de la maille considérée. Ce procédé permet également de mettre à jour la carte d'indicateurs de production lorsque des puits sont ajoutés séquentiellement dans le modèle de réservoir, sans avoir besoin de réaliser de nouvelles simulations. Par conséquent, grâce à cette méthode, on prend en compte les interférences entre puits, et ce, en un temps de calcul limité.

Cette approche requiert néanmoins un certain nombre de simulations d'écoulement, et ce nombre est d'autant plus grand que le nombre de mailles formant le modèle de réservoir est important. En effet, si le nombre de simulations considérées initialement est trop faible, la fiabilité du résultat déduit de la méthode d'interpolation est à remettre en cause.

Ainsi, le procédé selon l'invention vise à déterminer un positionnement de puits permettant d'améliorer significativement l'exploitation pétrolière d'une formation souterraine, et ce à moindre coût d'un point de vue temps de calcul. La diminution du nombre de simulations de réservoir impliquées dans le procédé selon l'invention par rapport au nombre de simulations requises dans l'art antérieur est compensée par une analyse physique des propriétés du modèle de réservoir.

### Le procédé selon l'invention

Ainsi, la présente invention concerne un procédé d'exploitation d'une formation souterraine traversée par au moins un puits à partir duquel un fluide est produit entre un temps t0 et un temps t1, à partir d'une grille, formée de mailles, représentative de la distribution de propriétés pétrophysiques de ladite formation, dans lequel on détermine une position d'au moins un nouveau puits à forer, caractérisé en ce que l'on réalise au moins les étapes suivantes :
a) on réalise une simulation de réservoir à partir de ladite grille et d'un simulateur de réservoir, depuis ledit temps t0 jusqu'à un temps t2 postérieur audit temps t1 ;
b) à partir d'au moins les résultats de la simulation de réservoir, on définit au moins un attribut représentatif des écoulements dans ladite formation et on applique une méthode de classification auxdits attributs pour les regrouper en classes ;
c) on calcule une valeur d'indicateur de qualité pour chacune desdites classes et on sélectionne au moins une classe telle que ledit indicateur est supérieur à un premier seuil prédéfini ;
d) on calcule une carte représentative de l'occurrence de ladite classe sélectionnée, l'occurrence étant calculée le long d'une courbe prédéfinie dans ladite grille, et on sélectionne les mailles de ladite carte pour lesquelles l'occurrence de ladite classe sélectionnée est supérieure à un deuxième seuil prédéfini ;
e) on définit ladite position dudit nouveau puits en fonction des positions desdites mailles sélectionnées.

Selon l'invention, au moins un attribut peut être choisi parmi les suivants : hauteur d'huile et/ou de gaz, la perméabilité relative à l'huile et/ou au gaz et ou/ à l'eau, la perméabilité horizontale, la pression de fluide, la saturation en huile et/ou en gaz et/ou en eau.

Selon l'invention, ladite courbe peut être une droite verticale.

Selon l'invention, ledit indicateur de qualité d'une classe peut être calculé à partir des valeurs moyennes des valeurs desdits attributs associés à ladite classe.

Selon un mode préféré de mise en oeuvre de l'invention, ledit indicateur de qualité d'une classe peut correspondre à la somme pour ladite classe des valeurs moyennes normalisées des valeurs d'au moins deux desdits attributs.

Selon l'invention, ladite position dudit nouveau puits peut correspondre à la maille parmi lesdites mailles sélectionnées pour laquelle ladite occurrence de ladite classe sélectionnée est la plus forte.

Selon l'invention, on peut réitérer les étapes a) à e), l'étape a) à une itération donnée supérieure ou égale à 2 étant réalisée en tenant compte de la position desdits nouveaux puits ajoutés à l'itération précédente.

Avantageusement, ladite simulation de réservoir de l'étape a) peut être réalisée uniquement entre lesdits temps t1 et t2 à partir de la deuxième itération.

Selon l'invention, on peut déterminer un nombre optimal de puits à forer, ainsi que l'ordre selon lequel forer lesdits puits entre lesdits temps t1 et t2.

Selon l'invention, ledit nombre optimal de puits à forer ainsi que de ledit ordre selon lequel forer lesdits puits peuvent être déterminés à partir de l'analyse de l'évolution de la production d'huile au cours du temps résultant de l'ajout d'au moins un nouveau puits.

Selon l'invention, ledit nouveau puits peut être un puits injecteur ou un puits producteur, vertical ou dévié, perforé sur toute la hauteur du puits ou en partie.

Avantageusement, on peut prendre en compte les incertitudes pour la détermination de la position dudit nouveau puits.

Préférentiellement, ladite méthode de classification peut être l'algorithme du K-means.

De manière préférée, ladite simulation de réservoir peut être réalisée entre ledit temps t1 et ledit temps t2 en tenant de coefficients multiplicateurs appliqués à des indices de productivité desdits premiers puits traversant ladite formation.

En outre, l'invention concerne un produit programme d'ordinateur téléchargeable depuis un réseau de communication et/ou enregistré sur un support lisible par ordinateur et/ou exécutable par un processeur, dans lequel il comprend des instructions de code de programme pour la mise en oeuvre du procédé selon l'une quelconque des revendications précédentes, lorsque ledit programme est exécuté sur un ordinateur.

Avantageusement, on peut réaliser des forages d'exploitation auxdites positions déterminées.

### Présentation succincte des Figures

D'autres caractéristiques et avantages du procédé selon l'invention, apparaîtront à la lecture de la description ci-après d'exemples non limitatifs de réalisations, en se référant aux figures annexées et décrites ci-après.
La Figure 1 présente une carte d'identification des régions obtenues par une méthode de classification d'attributs.
La Figure 2 présente une carte d'occurrence de la classe présentée en couleur blanche dans la Figure 1.
La Figure 3 présente les valeurs de l'attribut correspondant à la hauteur d'huile dans les mailles sélectionnées selon le procédé selon l'invention.
La Figure 4 présente la mise à jour de la carte d'identification des régions après ajout successif de 25 puits selon le procédé selon l'invention.
La Figure 5 présente une série de 25 courbes, chaque courbe correspondant au gain G de volume d'huile (en Million Stock Tank Barrels) en fonction du nombre de mois M, produit par l'ajout successif de 25 puits producteurs, à raison d'un puits par mois entre un temps t1 et un temps t2, selon le procédé selon l'invention.
La Figure 6 présente le gain G en volume d'huile (en Million stock tank barrels) produit au temps t2 en fonction du nombre de puits NP ajoutés selon le procédé selon l'invention.

### Description détaillée du procédé

Le procédé selon l'invention permet d'exploiter efficacement une formation souterraine contenant des hydrocarbures dans un réservoir. Le procédé permet de sélectionner des positions où placer un ou plusieurs nouveaux puits, producteurs ou injecteurs, de façon à améliorer la productivité du réservoir pétrolier.

Dans la suite, on va considérer trois temps distincts : t0, t1 et t2, où t0 représente le temps initial, avant la mise en production du réservoir, t1 est le temps jusqu'auquel des données, entre autres de production, ont été collectées, et t2 est un temps futur, pour lequel on veut prédire la production.

Le procédé selon l'invention requiert un modèle de réservoir représentatif des propriétés pétrophysiques de la formation souterraine étudiée, ainsi qu'une simulation de réservoir. On suppose que le modèle de réservoir respecte les données collectées jusqu'au temps t1. Le modèle de réservoir est une grille tridimensionnelle, formée de mailles, chaque maille étant associée par exemple à des valeurs de faciès, de porosité, de perméabilité, de saturation en eau, en huile, en gaz etc.

Le procédé selon l'invention comporte au moins les étapes suivantes :
a) on réalise une simulation de réservoir à partir de ladite grille et d'un simulateur de réservoir, depuis ledit temps t0 jusqu'à un temps t2 postérieur audit temps t1 ;
b) à partir d'au moins les résultats de la simulation de réservoir, on définit au moins un attribut représentatif des écoulements dans ladite formation et on applique une méthode de classification auxdits attributs pour les regrouper en classes ;
c) on calcule une valeur d'indicateur de qualité pour chacune desdites classes et on sélectionne au moins une classe telle que ledit indicateur est supérieur à un premier seuil prédéfini ;
d) on calcule une carte représentative de l'occurrence de ladite classe sélectionnée, l'occurrence étant calculée le long d'une courbe prédéfinie dans ladite grille, et on sélectionne les mailles de ladite carte pour lesquelles l'occurrence de ladite classe sélectionnée est supérieure à un deuxième seuil prédéfini ;
e) on définit ladite position dudit nouveau puits en fonction des positions desdites mailles sélectionnées.
Les principales étapes de la présente invention sont détaillées ci-après. Pour illustration, elles sont appliquées à un champ mature, en production, comportant déjà un nombre de puits significatif. L'objectif consiste à identifier les positions de nouveaux puits, permettant d'améliorer la productivité du réservoir, tout en limitant le recours à des étapes de simulations de réservoir.

### a) Simulation de réservoir

Au cours de cette étape, on effectue une simulation de réservoir entre un temps t0 et un temps t2 postérieur au temps t1, à partir d'un maillage représentatif des propriétés pétrophysiques du réservoir et d'un simulateur de réservoir, et pour les positions de puits déjà connues. Par exemple, le logiciel PumaFlow ® (IFP Energies nouvelles, France) est un simulateur de réservoir en milieu poreux dont la succession de calculs est exécutée sur un ordinateur. La simulation de réservoir permet de calculer, en chaque maille, des attributs représentatifs de l'écoulement dans la formation souterraine étudiée, tels que la hauteur d'huile et/ou de gaz, la perméabilité relative à l'huile et/ou au gaz et ou/ à l'eau, la perméabilité horizontale, la pression de fluide, la saturation en huile et/ou en gaz et/ou en eau.

La simulation de réservoir entre les temps t1 et t2 est prédictive et conduit habituellement à des discontinuités dans les courbes de débit d'huile des puits existants. Un puits existant est un puits qui a été ouvert avant de passer en phase de prédiction. Selon un mode de réalisation de l'invention, on utilise une technique bien connue des spécialistes consistant à ajuster, pendant la phase de prédiction, les coefficients multiplicateurs appliqués aux indices de productivité des puits existants de sorte à corriger les courbes de débit d'huile de ces discontinuités. Cette étape peut se faire de façon manuelle, par essai et erreur, ou encore de façon automatisée, soit à partir d'une fonctionnalité propre au simulateur de réservoir, soit à partir d'un algorithme d'optimisation.

### b) Classification des attributs

Au cours de cette étape, il s'agit de définir au moins un attribut représentatif des écoulements dans la formation souterraine étudiée, et d'appliquer une méthode de classification à ces attributs. On choisit au moins un attribut parmi des propriétés du réservoir mesurées ou simulées, telles que la hauteur d'huile et/ou de gaz, la perméabilité relative à l'huile et/ou au gaz et/ou à l'eau, la perméabilité horizontale, la pression de fluide, la saturation en huile et/ou en gaz et/ou en eau.

Selon un mode particulier de réalisation de la présente invention, un attribut peut résulter d'une opération appliquée à des propriétés du réservoir mesurées ou simulées. Selon un mode de réalisation de la présente invention, on calcule par exemple le produit de la perméabilité horizontale par la hauteur d'huile. Selon un autre mode de réalisation de l'invention, un attribut peut aussi résulter du calcul de la différence de pression de fluide entre les temps t2 et t1, ou bien de la différence entre la pression au temps t1 et la pression d'abandon.

Selon un autre mode particulier de mise en oeuvre de la présente invention, un attribut supplémentaire correspond à la distance entre chaque maille de la grille et le puits existant le plus proche. Avantageusement, la distance utilisée est de type euclidienne.

Des attributs caractérisant le réservoir étant définis, on applique une méthode de classification à au moins un de ces attributs, pour les analyser et les séparer en classes. La classification est une méthode bien connue des spécialistes consistant à regrouper des points par famille, les points d'une même famille présentant des caractéristiques communes. Appliquée à des valeurs attributs d'une grille, la classification revient à regrouper les mailles de la grille ayant des valeurs d'attributs proches. On peut alors attribuer à chaque maille un indicateur spécifiant à quelle classe, ou encore à quelle famille, elle appartient.

Dans un mode de réalisation préférentiel de la présente invention, la classification se fait suivant l'algorithme du K-means, qui permet de regrouper les valeurs des attributs en K classes ne se chevauchant pas. On choisit un nombre de classes (ou coefficient K), en général inférieur à 10, afin d'obtenir un résultat relativement stable. Cet algorithme présente les avantages d'une simplicité conceptuelle, d'une rapidité d'exécution et de faibles exigences en taille mémoire.

Selon un mode de réalisation de la présente invention, les attributs peuvent être pondérés avant de procéder à leur classification. De cette façon, on peut ainsi renforcer l'impact de certains attributs, comme par exemple la hauteur d'huile, par rapport à d'autres.

La grille obtenue est tri-dimensionnelle et est de ce fait difficile à appréhender. Selon un mode particulier de mise en oeuvre de l'invention, pour simplifier l'analyse de cette information, on construit une carte bi-dimensionnelle présentant, pour chaque maille, l'indicateur de la classe dont l'occurrence est majoritaire le long d'une courbe donnée. On obtient ainsi une carte d'identification des régions, distinguant des régions du réservoir pour lesquelles les attributs appartiennent à une même classe. Les mailles appartenant à une même région sont donc caractérisées par des valeurs d'attributs proches ou similaires.

Selon un mode particulier de mise en oeuvre de l'invention, on considère une courbe, de forme prédéfinie et on place cette courbe en une maille de la grille. La position verticale de cette maille dans la grille définit un niveau, niveau le long duquel est construite la carte d'identification des régions. La carte d'identification des régions est formée de mailles bidimensionnelles, les limites des mailles de la carte d'identification des régions correspondant aux limites des mailles de la grille pour le niveau choisi. Puis, on compte le nombre de mailles de la grille, associées à chacune des classes considérées, et qui sont traversées par la courbe ainsi positionnée. L'indicateur de la classe ayant l'occurrence la plus forte est attribuée à la maille dans la carte d'identification des régions dont les limites correspondent à celles de la maille choisie dans la grille. Puis on répète l'opération pour toutes les mailles de la grille le long du niveau considéré. On obtient ainsi une carte bidimensionnelle, formée de mailles, chaque maille contenant l'indicateur de la classe ayant l'occurrence la plus forte.

Selon un mode de réalisation de la présente invention, la courbe est une droite verticale. La carte d'identification des régions représente alors les indicateurs des classes majoritaires par colonne dans la grille considérée.

Selon un mode de réalisation préféré de la présente invention, le niveau le long duquel est calculée la carte d'identification des régions correspond à la face supérieure de la grille considérée.

Avantageusement, le résultat du calcul de cartes d'identification de régions peut être affiché au spécialiste sur un écran d'ordinateur. Cette caractéristique permet éventuellement de modifier les paramètres de classification de sorte à aboutir à des classes bien distinctes les unes des autres.

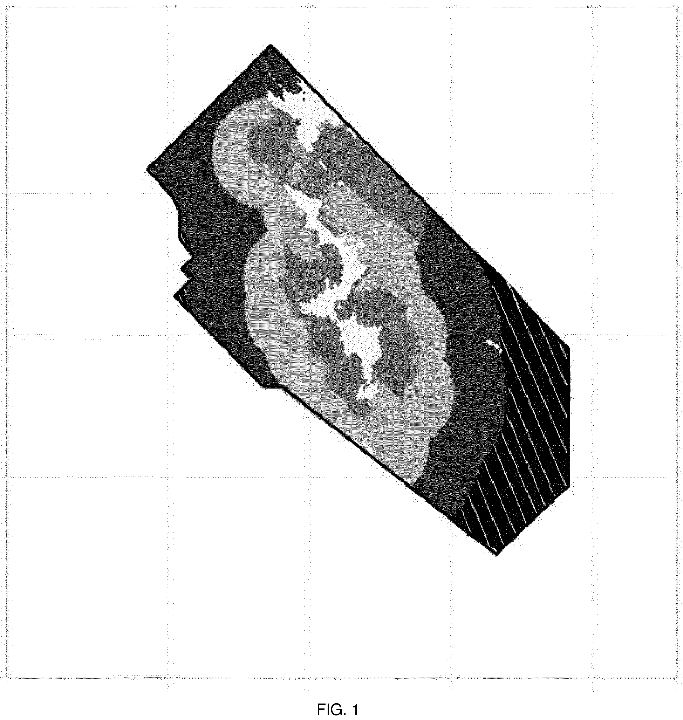

La Figure 1 représente un exemple de carte d'identification des régions obtenue par application d'une méthode de classification à des attributs issus de l'exemple décrit au début de la description. Le nombre de classes a été fixé à cinq pour l'application de la méthode de classification, et une droite verticale a été utilisée pour construire la carte d'identification des régions. On distingue sur cette carte cinq régions différentes, reflétant les cinq classes majoritaires par colonne verticale dans la grille tridimensionnelle.

A noter que certaines mailles ne sont pas prises en compte dans cette analyse, par exemple les mailles mortes (c'est-à-dire les mailles de porosité nulle) ou les mailles sous le contact eau/huile.

### c) Calcul d'un indicateur de qualité des classes

Au cours de cette étape, on calcule un indicateur représentatif de la qualité de chacune des classes issues de l'étape de classification des attributs décrite à l'étape b).

Selon un mode de mise en oeuvre de la présente invention, on construit un indicateur de qualité représentatif d'une classe à partir des moyennes des valeurs des attributs associés à la classe considérée. Le Tableau 1 présente les valeurs moyennes, calculées sur un nombre NS d'échantillons présents dans les classes notées C1 à C5, de différents attributs : HOIL_3D correspondant à la hauteur d'huile 3D, HOIL_2D correspondant à la hauteur d'huile 2D, HUKH_3D correspondant au produit de l'épaisseur des mailles par la perméabilité absolue horizontale, KHKRO-3D au produit de la perméabilité horizontale par la perméabilité relative à l'huile, DP_3D à la différence de pression entre les temps t2 et t1, et DIST 3D à la distance en 3D au puits existant le plus proche.

Selon un mode particulier de mise en oeuvre de la présente invention, on construit un indicateur de qualité représentatif de chacune des classes de la façon suivante :
- Pour chaque attribut, on calcule la valeur moyenne par classe des valeurs prises par cet attribut (Tableau 1). Pour un attribut donné, on obtient ainsi une valeur d'attribut moyenne pour chacune des classes.
- Pour chaque attribut, on procède à la normalisation des valeurs moyennes par classe (Tableau 2). On obtient ainsi, pour un attribut donné, des valeurs moyennes par classe comprises entre 0 et 1. Si besoin, on applique une correction à ces valeurs moyennes normalisées, de sorte à ce que les valeurs les plus proches de 1 correspondent à un potentiel pétrolier élevé.
- Pour chaque classe, on somme les valeurs moyennes normalisées d'au moins deux attributs de cette classe. Le Tableau 3 présente la somme des moyennes normalisées des attributs HOIL_2D, HUKH_3D, KHKRO-3, DP_3D et DIST 3D. Selon un mode particulier de réalisation de la présente invention, on applique une pondération sur les attributs préalablement à la sommation des moyennes normalisées, de sorte à donner un poids plus important à certains attributs par rapport à d'autres dans le calcul de l'indicateur de qualité.

Puis, une fois un indicateur de qualité calculé pour chacune des classes d'intérêt, on peut procéder à l'analyse de leur indicateur de qualité. Ainsi, l'indicateur de qualité permet d'ordonner les classes et d'identifier la ou les classes, et donc la ou les régions du réservoir, dont le potentiel pétrolier est le plus important. Par exemple d'après le Tableau 3, la classe C2 apparaît comme la classe la plus avantageuse, c'est-à-dire présentant le meilleur potentiel pétrolier.

Selon le procédé selon l'invention, une fois un indicateur de qualité calculé pour chaque classe, on sélectionne la ou les classes dont l'indicateur de qualité est supérieur à un seuil prédéfini.

Selon un mode de réalisation de la présente invention, on sélectionne la ou les classes dont l'indicateur de qualité est supérieur de 150% à la moyenne des indicateurs de qualité

Selon un mode préféré de réalisation de la présente invention, on sélectionne la classe dont l'indicateur de qualité est le plus élevé.

Avantageusement, le résultat du calcul d'indicateur de qualité est affiché au préalable au spécialiste sur un écran d'ordinateur. Cette caractéristique permet au spécialiste de choisir un seuil pertinent au-delà duquel la ou les classes sont considérées comme ayant un potentiel pétrolier intéressant.

**Tableau 1**

| | **C1** | **C2** | **C3** | **C4** | **C5** |
|---|---|---|---|---|---|
| **NS** | 31915 | 3362 | 13289 | 4748 | 8103 |
| **HOIL_D** | 0,34 | 1,26 | 0,50 | 0,76 | 1,29 |
| **HOIL_2D** | 4,81 | 7,36 | 5,26 | 4,39 | 9,16 |
| **HUKH_3D** | 680,55 | 2096,40 | 951,21 | 1222,10 | 2023,90 |
| **KHKRO_3D** | 5,70 | 177,25 | 17,09 | 43,00 | 79,44 |
| **DP_3D** | -386,57 | -112,08 | -134,44 | -247,13 | -463,97 |
| **DIST_3D** | 605,04 | 2173,80 | 1157,40 | 4488,20 | 532,02 |

**Tableau 2**

| | **C1** | **C2** | **C3** | **C4** | **C5** |
|---|---|---|---|---|---|
| **HOLD_3D** | 0,00 | 0,97 | 0,17 | 0,44 | 1,00 |
| **HOIL_2D** | 0,09 | 0,62 | 0,18 | 0,00 | 1,00 |
| **HUKH_3D** | 0,00 | 1,00 | 0,19 | 0,38 | 0,95 |
| **KHKRO_3D** | 0,00 | 1,00 | 0,07 | 0,22 | 0,43 |
| **DP**_**3D** | 0,22 | 1,00 | 0,94 | 0,62 | 0,00 |
| **DIST**_**3D** | 0,02 | 0,41 | 0,16 | 1,00 | 0,00 |

**Tableau 3**

| | **C1** | **C2** | **C3** | **C4** | **C5** |
|---|---|---|---|---|---|
| **Indicateur de qualité** | 0,33 | 4,04 | 1,53 | 2,22 | 2,38 |
| **Classement** | **5** | **1** | **4** | **3** | **2** |

### d) Construction d'une carte d'occurrence de classe

Au cours de cette étape, il s'agit de construire une carte représentative de l'occurrence, le long d'une courbe donnée dans la grille, d'au moins une classe issue de l'étape b). Plus précisément, on construit une carte bi-dimensionnelle présentant, pour chaque maille, l'occurrence d'une classe donnée le long d'une courbe traversant la grille.

Selon un mode particulier de mise en oeuvre de l'invention, on considère une courbe, de forme prédéfinie et on place cette courbe en une maille de la grille. La position verticale de cette maille dans la grille définit un niveau, niveau le long duquel est construite la carte d'occurrence. La carte d'occurrence est formée de mailles bidimensionnelles, les limites des mailles de la carte d'occurrence correspondant aux limites des mailles de la grille pour le niveau choisi. Puis, pour une classe donnée, on compte le nombre de mailles de la grille associées à la classe considérée et qui sont traversées par la courbe ainsi positionnée. L'occurrence ainsi calculée est attribuée à la maille dans la carte d'occurrence dont les limites correspondent à celles de la maille choisie dans la grille. Puis on répète l'opération pour toutes les mailles de la grille le long du niveau considéré. On obtient ainsi une carte bidimensionnelle, formée de mailles, chaque maille contenant l'occurrence de la classe considérée. Selon un mode réalisation préféré de la présente invention, le niveau le long duquel est calculée la carte d'occurrence correspond à la face supérieure de la grille considérée. Avantageusement, le niveau choisi pour construire la carte d'occurrence est le même que le niveau choisi pour construire la carte d'idenfication des régions.

Selon un mode de réalisation de la présente invention, on construit une carte d'occurrence pour chaque classe issue de l'étape b).

Selon un mode préféré de réalisation de la présente invention, on construit une carte d'occurrence pour la ou les classes sélectionnées lors de l'étape c).

Selon un mode particulier de mise en oeuvre de la présente invention, la courbe est une droite verticale. Ce mode est en particulier utilisé lorsque l'on souhaite positionner un puits vertical.

Avantageusement, la courbe choisie pour construire la carte d'occurrence a la même forme que la courbe choisie pour construire la carte d'identification des régions.

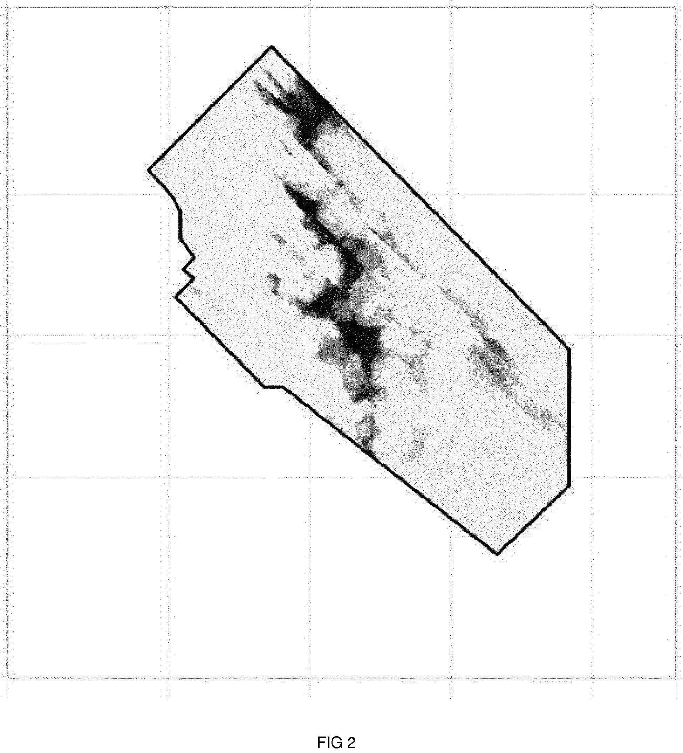

Un exemple de carte d'occurrence pour la classe présentée en couleur blanche dans la Figure 1 est présentée en Figure 2. Les couleurs claires correpondent aux zones dont l'occurrence de la classe étudiée est faible, et les couleurs foncées correspondent aux zones dont l'occurrence de la classe étudiée est la plus forte.

Puis, pour au moins une classe sélectionnée à l'étape c), on sélectionne les mailles, dans la carte d'occurrence de la classe considérée, qui sont associées à une occurrence supérieure à un seuil prédéfini.

Avantageusement, la ou les cartes d'occurrence pour la ou les classes sélectionnées sont affichées au spécialiste sur un écran d'ordinateur. Cette caractéristique peut aussi permettre au spécialiste de définir un seuil au-delà duquel l'occurrence d'une classe donnée est jugée suffisante pour que cette classe soit considérée comme intéressante d'un point de vue potentiel pétrolier.

Selon un mode particulier de mise en oeuvre de l'invention, la valeur du seuil portant sur l'occurrence sera égale à 75%.

Selon un mode préféré de réalisation de l'invention, on sélectionne, pour chaque classe sélectionnée à l'étape c), les mailles de la carte d'occurrence construite pour cette classe qui ont l'occurrence la plus forte.

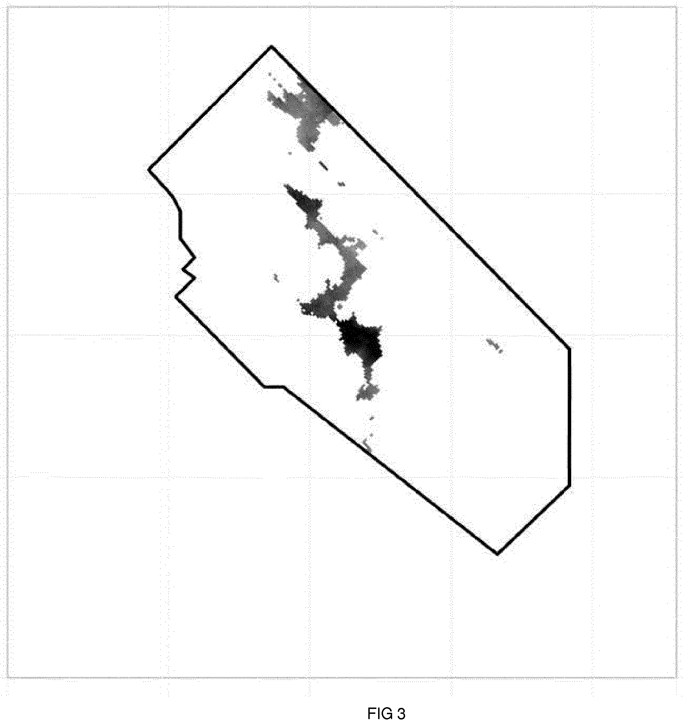

Selon un autre mode de réalisation de la présente invention, on affine la sélection des mailles telle que décrite précédemment en fonction de la valeur d'au moins un attribut pertinent. Par exemple, si l'on choisit la hauteur d'huile comme attribut pertinent, on choisira, parmi les mailles sélectionnées, celles qui sont associées à une hauteur d'huile supérieure à un certain seuil. La Figure 3 montre par exemple la carte de répartition de la hauteur d'huile dans les mailles sélectionnées sur la base de l'occurrence des classes tel que décrit précédemment. Les couleurs les plus foncées montrent les zones où la hauteur d'huile est la plus importante, et donc les zones où le potentiel pétrolier est a priori le plus important.

### e) Positionnement des puits

Au cours de cette étape, il s'agit de déterminer la position d'au moins un nouveau puits dans la grille.

Selon un mode de réalisation de la présente invention dans lequel le spécialiste place un seul nouveau puits, le spécialiste positionne ledit nouveau puits dans la maille, parmi les mailles sélectionnées à l'étape d), ayant l'occurrence la plus forte. Ainsi, on sélectionne la maille correspondant à la classe ayant le meilleur potentiel pétrolier et étant le plus souvent présente le long d'une courbe donnée.

Selon un mode de réalisation de la présente invention dans lequel le spécialiste place *p* nouveaux puits, le spécialiste positionne lesdits *p* nouveaux puits dans les *p* mailles, parmi les mailles sélectionnées à l'étape d), ayant l'occurrence la plus forte.

Selon un mode particulier de réalisation de la présente invention, les cartes, par exemple d'identification des régions et d'occurrence, sont affichées au spécialiste sur un écran d'ordinateur de sorte à ce qu'il puisse affiner le positionnement du ou des nouveaux puits à forer.

Selon un autre mode réalisation de la présente invention, le spécialiste place au moins un nouveau puits à proximité des mailles sélectionnées.

Selon un mode de réalisation de la présente invention, les puits ajoutés sont perforés au-dessus du contact eau-huile. Avantageusement, la visualisation des valeurs des attributs le long de la courbe prédéfinie permet de préciser le niveau de perforation des puits.

### Variantes

### Positionnement successif de nouveaux puits.

Au cours de cette étape, il s'agit de définir la façon selon laquelle placer successivement un ou plusieurs nouveaux puits.

Dans le cas où un nombre *P* de nouveaux puits sont à placer, le spécialiste peut les placer tous ensemble ou séquentiellement, un par un, ou groupe de *p* par groupe de *p* puits, où *p* est un nombre inférieur ou égal à *P.* Les *p* nouveaux puits peuvent être ajoutés au temps *t1,* ou à des intervalles de temps *Δt* à partir de *t1, Δt* correspondant par exemple à 1 mois. L'avantage de placer les puits par groupe est de réduire les temps de calcul requis par les simulations d'écoulement successives.

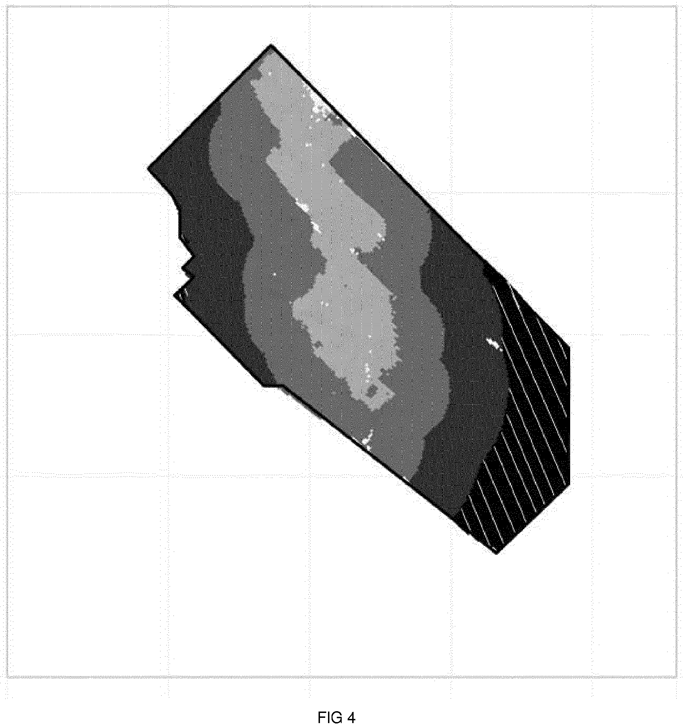

Cette étape est déclinée ci-après dans le cas de *P* nouveaux puits, ajoutés par groupe de *p* puits, selon un ordre à définir. Dans ce cas, le procédé selon l'invention peut être réalisé de la façon suivante :
- On applique les étapes a) à e) du procédé selon l'invention tel que précédemment décrit pour déterminer la position du premier groupe de *p* puits ;
- Puis on reitère les étapes a) à e), l'étape a) de simulation de réservoir étant appliquée en tenant compte de la position des *p* puits ainsi déterminées.
De cette façon, à chaque itération *I,* telle que *I≥2,* du procédé selon l'invention, on met à jour les valeurs des attributs identifiés pour la mise en oeuvre de la présente invention. La Figure 4 montre la carte des attributs de l'exemple précédent mise à jour après l'ajout de 25 puits, à raison de un puits par mois. Selon un mode de réalisation de la présente invention, on met également à jour la grille des distances au puits le plus proche. La classification réalisée à l'étape b) d'une itération *I,* avec *I≥2,* tient donc compte de l'impact des *p* puits positionnés à l'étape *I-1.* Puis le processus est répété jusqu'à ce que les *P* puits aient été ajoutés.

Avantageusement, la simulation de réservoir mise en oeuvre à l'étape a) est réalisée uniquement entre les temps t1 et t2 pour *I*≥*2*.

### Nombre optimal de puits à forer et ordre de placement des puits

Au cours de cette étape, il s'agit de définir le nombre optimal de puits à forer pour le réservoir étudié, ainsi que l'ordre selon lequel forer ces puits.

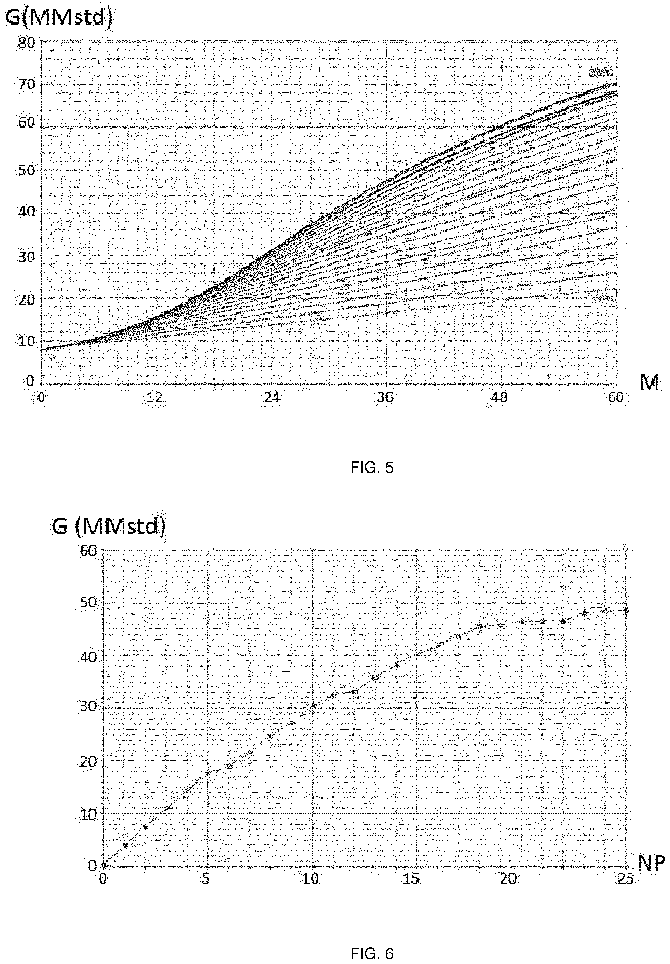

Selon un mode de réalisation de la présente invention dans lequel *P* puits ont été successivement positionnés comme décrit précédemment, on évalue la production d'huile au cours du temps liée à chaque ajout d'un puits ou d'un groupe de puits via une simulation de réservoir. La Figure 5 présente une série de 25 courbes issues de l'application du procédé selon l'invention sur le cas étudié, chaque courbe correspondant au gain cumulé en volume d'huile obtenu par l'ajout successif de 25 puits entre les temps t1 et t2, à raison d'un puits par mois.

Selon un mode préféré de réalisation de la présente invention, on estime l'incrément d'huile produite pour chaque puits ou pour chaque groupe de puits ajouté. L'analyse de cette courbe permet de recommender un nombre de puits optimal à forer puisqu'à partir d'un certain nombre de puits, l'ajout d'un nouveau puits ne contribue que modestement à augmenter la production. La Figure 6 présente le gain cumulé d'huile produite en fonction du nombre de nouveaux puits ajoutés. On peut ainsi observer que la courbe de cumulé d'huile atteint un plateau à partir du dix-huitième puits ajouté. A noter aussi qu'à un moment donné, le gain en production lié à l'ajout d'un puits peut être inférieur au coût de son forage. On observe aussi que certains puits ajoutés permettent un gain en production plus important que d'autres et que ces puits ne sont pas nécessairement ceux ajoutés en premier. Par exemple sur la Figure 6, le puits 7 apparaît comme apportant un incrément d'huile plus important que le puits 6. Ainsi, on peut réordonner chronologiquement l'ajout des puits en fonction du gain en production calculé. Les positions des puits restent les mêmes que celles déterminées précédemment.

Avantageusement, on pourra relancer une simulation de réservoir tenant compte du nombre optimal de puits à forer et de l'ordre chronologique ainsi déterminés afin d'obtenir une nouvelle évaluation de la production d'huile et de confirmer ou non les choix réalisés à l'aide du procédé selon l'invention. Si les choix ne s'avéraient pas optimaux, le spécialiste pourrait relancer le procédé selon l'invention pour déterminer par exemple de nouvelles positions de puits, ou encore changer l'ordre ou le nombre de puits à forer.

En pratique, le spécialiste a tendance à considérer une période de temps *t2-t1* très longue, souvent de l'ordre de 30 ans. Il est possible de se limiter à une période plus courte, de quelques années, pour réaliser l'étude de positionnement de puits d'après le procédé selon l'invention. Une fois l'étude réalisée, la position des puits et l'ordre chronologique d'ajout des puits étant définis, le spécialiste pourra simuler les écoulements avec l'ensemble des puits jusqu'à un temps *t2* plus important.

Dans le cadre de l'exemple traité pour décrire les étapes de la présente invention, le procédé selon l'invention a nécessité seulement 25 simulations de réservoir pour placer 25 nouveaux puits, puisque les 25 puits ont été ajoutés un à un, mois après mois. Ce nombre de simulations de réservoir aurait toutefois pu être réduit, par exemple en ajoutant les puits 3 par 3. On aurait eu alors 8 fois recours au simulateur d'écoulement. Malgré cela, la réduction en temps de calcul est significative par rapport à l'art antérieur. En effet, si une optimisation classique de positionnement de puits avait été lancée, le nombre de simulations d'écoulement aurait été de l'ordre de quelques centaines. Et si une approche basée sur la construction d'une carte d'indicateurs de production déterminés par interpolation (EP 2568110 - US 2013/0020131) avait été utilisée, le nombre de simulations de réservoir aurait été de l'ordre d'au moins une cinquantaine.

### Prise en compte des incertitudes

Le procédé selon l'invention peut tenir compte d'incertitudes établies à partir de la fiabilité des informations connues au niveau des puits existants.

Le modèle de réservoir utilisé par le procédé selon l'invention est un modèle contraint par les données de production acquises pendant la période *t0-t1.* Or certains puits peuvent être mieux calés dans certaines zones que dans d'autres. La qualité du calage reflète directement cette notion d'incertitude. Mieux les puits sont calés et plus faible est l'incertitude dans les zones autour de ces puits.

Selon un mode de réalisation de la présente invention, on définit l'incertitude à un puits donné par la différence, pondérée ou non, de type moindre carré entre données de production mesurées au puits en question et données de production simulées pour ce même puits. Il en résulte que quand l'erreur est petite, l'incertitude est faible.

Selon un mode de mise en oeuvre de la présente invention, on crée une carte d'incertitudes en interpolant les incertitudes estimées aux puits. On crée ainsi une carte bidimensionnelle formée de mailles, chaque maille étant associée à une incertitude. Avantageusment, les limites des mailles ainsi que le niveau sur un axe vertical de cette carte sont les mêmes que ceux de la carte d'identification des régions et/ou que ceux de la carte d'occurrence. Selon un mode de réalisation, cette interpolation est réalisé par une méthode de krigeage, bien connue des spécialistes.

Selon un mode de réalisation de la présente invention, les incertitudes ainsi calculées sont utilisées comme une pondération s'appliquant aux attributs, tels que la hauteur d'huile, avant l'étape b) de classification.

Selon un mode de réalisation de la présente invention, la sélection des mailles candidates au positionnement d'au moins un puits tient compte des incertitudes ainsi calculées. Ainsi, si une maille figurant parmi les mailles candidates à la fin de l'étape d) est associée à une incertitude supérieure à un seuil prédéfini, alors cette maille n'est pas sélectionnée.

Selon un mode de réalisation de la présente invention, la carte des incertitudes calculée tel que décrit précédemment est affichée sur un écran d'ordinateur. Ainsi, lorsque le spécialiste se réfère à la carte d'identification des régions et à la carte d'occurrence pour sélectionner la position d'un puits, il peut vérifier si cette position est dans une zone où l'incertitude est forte ou non. Ainsi, une position située dans une zone où l'incertitude serait supérieure à un certain seuil fixé par le spécialiste ne serait pas retenue.

## Revendications

1. Procédé d'exploitation d'une formation souterraine traversée par au moins un puits à partir duquel un fluide est produit entre un temps t0 et un temps t1, à partir d'une grille, formée de mailles, représentative de la distribution de propriétés pétrophysiques de ladite formation, dans lequel on détermine une position d'au moins un nouveau puits à forer, **caractérisé en ce qu'**il comprend au moins les étapes suivantes :
a) on réalise une simulation de réservoir à partir de ladite grille et d'un simulateur de réservoir, depuis ledit temps t0 jusqu'à un temps t2 postérieur audit temps t1 ;
b) à partir d'au moins les résultats de la simulation de réservoir, on définit au moins un attribut représentatif des écoulements dans ladite formation et on applique une méthode de classification auxdits attributs pour les regrouper en classes ;
c) on calcule une valeur d'indicateur de qualité pour chacune desdites classes et on sélectionne au moins une classe telle que ledit indicateur est supérieur à un premier seuil prédéfini ;
d) on calcule une carte représentative de l'occurrence de ladite classe sélectionnée, l'occurrence étant calculée le long d'une courbe prédéfinie dans ladite grille, et on sélectionne les mailles de ladite carte pour lesquelles l'occurrence de ladite classe sélectionnée est supérieure à un deuxième seuil prédéfini ;
e) on définit ladite position dudit nouveau puits en fonction des positions desdites mailles sélectionnées.

2. Procédé selon la revendication 1, dans lequel au moins un attribut est choisi parmi les suivants : hauteur d'huile et/ou de gaz, la perméabilité relative à l'huile et/ou au gaz et ou/ à l'eau, la perméabilité horizontale, la pression de fluide, la saturation en huile et/ou en gaz et/ou en eau.

3. Procédé selon l'une quelconque des revendications précédentes, dans lequel ladite courbe est une droite verticale.

4. Procédé selon l'une quelconque des revendications précédentes, dans lequel ledit indicateur de qualité d'une classe est calculé à partir des valeurs moyennes des valeurs desdits attributs associés à ladite classe.

5. Procédé selon l'une quelconque des revendications précédentes, dans lequel ledit indicateur de qualité d'une classe correspond à la somme pour ladite classe des valeurs moyennes normalisées des valeurs d'au moins deux desdits attributs.

6. Procédé selon l'une quelconque des revendications précédentes, dans lequel ladite position dudit nouveau puits correspond à la maille parmi lesdites mailles sélectionnées pour laquelle ladite occurrence de ladite classe sélectionnée est la plus forte.

7. Procédé selon l'une quelconque des revendications précédentes, dans lequel, on réitère les étapes a) à e), l'étape a) à une itération donnée supérieure ou égale à 2 étant réalisée en tenant compte de la position desdits nouveaux puits ajoutés à l'itération précédente.

8. Procédé selon la revendication 7, dans lequel ladite simulation de réservoir de l'étape a) est réalisée uniquement entre lesdits temps t1 et t2 à partir de la deuxième itération.

9. Procédé selon l'une des revendications 7 à 8, dans lequel on détermine un nombre optimal de puits à forer, ainsi que l'ordre selon lequel forer lesdits puits entre lesdits temps t1 et t2.

10. Procédé selon la revendication 9, dans lequel ledit nombre optimal de puits à forer ainsi que de ledit ordre selon lequel forer lesdits puits sont déterminés à partir de l'analyse de l'évolution de la production d'huile au cours du temps résultant de l'ajout d'au moins un nouveau puits.

11. Procédé selon l'une quelconque des revendications précédentes, dans lequel ledit nouveau puits est un puits injecteur ou un puits producteur, vertical ou dévié, perforé sur toute la hauteur du puits ou en partie.

12. Procédé selon l'une quelconque des revendications précédentes, dans lequel on prend en compte les incertitudes pour la détermination de la position dudit nouveau puits.

13. Procédé selon l'une quelconque des revendications précédentes, dans lequel ladite méthode de classification est l'algorithme du K-means.

14. Procédé selon l'une quelconque des revendications précédentes, dans lequel ladite simulation de réservoir est réalisée entre ledit temps t1 et ledit temps t2 en tenant de coefficients multiplicateurs appliqués à des indices de productivité desdits premiers puits traversant ladite formation.

15. Procédé selon l'une quelconque des revendications 1 à 14, dans lequel on réalise des forages d'exploitation auxdites positions déterminées.

16. Produit programme d'ordinateur téléchargeable depuis un réseau de communication et/ ou enregistré sur un support lisible par ordinateur et/ou exécutable par un processeur, dans lequel il comprend des instructions de code de programme pour la mise en oeuvre du procédé selon l'une quelconque des revendications 1 à 14. lorsque ledit programme est exécuté sur un ordinateur.

## Patentansprüche

1. Verfahren zur Erschließung einer unterirdischen Formation, die von mindestens einem Bohrloch durchquert wird, ausgehend von dem eine Flüssigkeit zwischen einer Zeit t0 und einer Zeit t1 ausgehend von einem Raster, das aus Rasterelementen gebildet ist, das für die Verteilung von petrophysikalischen Eigenschaften der Formation repräsentativ ist, erzeugt wird, wobei eine Position von mindestens einem neuen zu bohrenden Bohrloch bestimmt wird, **dadurch gekennzeichnet, dass** es mindestens die folgenden Schritte aufweist:
a) es wird eine Reservoirsimulation ausgehend von dem Raster und von einem Reservoirsimulator von der Zeit t0 bis zu einer Zeit t2, die nach der Zeit t1 liegt, durchgeführt;
b) ausgehend von mindestens einem der Ergebnisse der Reservoirsimulation wird mindestens ein Attribut definiert, das für die Strömungen in der Formation repräsentativ ist, und es wird ein Klassifikationsverfahren auf die Attribute angewendet, um sie in Klassen zu gruppieren;
c) es wird ein Qualitätsindikatorwert für jede der Klassen berechnet und es wird mindestens eine derartige Klasse ausgewählt, dass der Indikator höher als ein erster vorgegebener Schwellenwert ist;
d) es wird eine Karte berechnet, die für das Auftreten der ausgewählten Klasse repräsentativ ist, wobei das Auftreten entlang einer vorgegebenen Kurve in dem Raster berechnet wird, und es werden die Rasterelemente der Karte ausgewählt, für die das Auftreten der ausgewählten Klasse höher als ein zweiter vorgegebener Schwellenwert ist;
e) es wird die Position des neuen Bohrlochs in Abhängigkeit von der Positionen der ausgewählten Rasterelemente definiert.

2. Verfahren nach Anspruch 1, wobei mindestens ein Attribut aus den folgenden ausgewählt wird: Höhe des Öls und/oder des Gases, die relative Öl- und/oder Gas- und/oder Wasserpermeabilität, die horizontale Permeabilität, der Flüssigkeitsdruck, die Öl- und/oder Gas- und/oder Wassersättigung.

3. Verfahren nach einem der vorangehenden Ansprüche, wobei die Kurve eine vertikale Gerade ist.

4. Verfahren nach einem der vorhergehenden Ansprüche, wobei der Qualitätsindikator einer Klasse ausgehend von den Mittelwerten der Werte der Attribute berechnet wird, die mit der Klasse verbunden sind.

5. Verfahren nach einem der vorhergehenden Ansprüche, wobei der Qualitätsindikator einer Klasse der Summe für die Klasse der normalisierten Mittelwerte der Werte von mindestens zwei der Attribute entspricht.

6. Verfahren nach einem der vorhergehenden Ansprüche, wobei die Position des neuen Bohrlochs des Rasterelements unter den ausgewählten Rasterelementen entspricht, für die das Auftreten der ausgewählten Klasse das stärkste ist.

7. Verfahren nach einem der vorhergehenden Ansprüche, wobei die Schritte a) bis e) reiteriert werden, wobei der Schritt a) bei einer gegebenen Iteration, die höher als oder gleich 2 ist, durchgeführt wird, indem die Position der neuen Bohrlöcher berücksichtigt wird, die zu der vorhergehenden Iteration hinzugefügt werden.

8. Verfahren nach Anspruch 7, wobei die Reservoirsimulation des Schrittes a) nur zwischen den Zeiten t1 und t2 ausgehend von der zweiten Iteration durchgeführt wird.

9. Verfahren nach einem der Ansprüche 7 bis 8, wobei eine optimale Anzahl von zu bohrenden Bohrlöchern sowie die Reihenfolge, in der die Bohrlöcher zwischen den Zeiten t1 und t2 zu bohren sind, bestimmt wird.

10. Verfahren nach Anspruch 9, wobei die optimale Anzahl von zu bohrenden Bohrlöchern sowie die Reihenfolge, in der die Bohrlöcher zu bohren sind, ausgehend von der Analyse der Entwicklung der Ölproduktion im Laufe der Zeit, die sich aus dem Hinzufügen von mindestens einem neuen Bohrloch ergibt, bestimmt werden.

11. Verfahren nach einem der vorhergehenden Ansprüche, wobei das neue Bohrloch ein Injektionsbohrloch oder ein Förderbohrloch ist, das vertikal oder abgelenkt ist, das über die ganze Höhe des Bohrlochs oder teilweise perforiert ist.

12. Verfahren nach einem der vorangehenden Ansprüche, wobei die Unsicherheiten für das Bestimmen der Position des neuen Bohrlochs berücksichtigt werden.

13. Verfahren nach einem der vorangehenden Ansprüche, wobei die Klassifizierungsmethode der K-Means Algorithmus ist.

14. Verfahren nach einem der vorhergehenden Ansprüche, wobei die Reservoirsimulation zwischen der Zeit t1 und der Zeit t2 durchgeführt wird, indem Multiplikatorkoeffizienten, die auf Produktivitätsindexe der ersten Bohrlöcher angewendet werden, die die Formation durchqueren, berücksichtigt werden.

15. Verfahren nach einem der Ansprüche 1 bis 14, wobei Förderbohrungen an den vorbestimmten Positionen durchgeführt werden.

16. Computerprogrammprodukt, das von einem Kommunikationsnetz heruntergeladen werden kann und/oder auf einem computerlesbaren Medium gespeichert ist und/oder von einem Prozessor ausgeführt werden kann, wobei es Programmcodebefehle für das Umsetzen des Verfahrens nach mindestens einem der Ansprüche 1 bis 14 aufweist, wenn das Programm auf einem Computer ausgeführt wird.

## Claims

1. A method for developing an underground formation traversed by at least one wellbore from which a fluid is produced between a time t0 and a time t1, from a grid made up cells, representative of the distribution of physical properties of said formation, wherein a location of at least one new wellbore to be drilled is determined, **characterized in that** it comprises at least the following stages:
a) performing a reservoir simulation from said grid and from a reservoir simulator, from said time t0 to a time t2 later than said time t1;
b) from at least the reservoir simulation results, defining at least one attribute representative of the flows in said formation and applying a classification method to said attributes so as to arrange them in classes;
c) calculating a quality indicator value for each one of said classes and selecting at least one class such that said indicator is greater than a first predetermined threshold;
d) calculating a map representative of the occurrence of said selected class, the occurrence being calculated along a predetermined curve in said grid, and selecting the cells of said map for which the occurrence of said selected class is greater than a second predetermined threshold;
e) defining said location of said new wellbore as a function of the positions of said selected cells.

2. A method as claimed in claim 1, wherein at least one attribute is selected from among: oil and/or gas height, relative oil and/or gas and/or water permeability, horizontal permeability, fluid pressure, oil and/or gas and/or water saturation.

3. A method as claimed in any one of the previous claims, wherein said curve is a vertical line.

4. A method as claimed in any one of the previous claims, wherein said quality indicator of a class is calculated from the average values of the values of said attributes associated with said class.

5. A method as claimed in any one of the previous claims, wherein said quality indicator of a class corresponds to the sum for said class of the normalized average values of the values of at least two of said attributes.

6. A method as claimed in any one of the previous claims, wherein said location of said new wellbore corresponds to the cell among said selected cells for which said occurrence of said selected class is the highest.

7. A method as claimed in any one of the previous claims, wherein stages a) to e) are reiterated, stage a) at a given iteration greater than or equal to 2 being carried out by taking account of the location of said new wellbores added in the previous iteration.

8. A method as claimed in claim 7, wherein said reservoir simulation of stage a) is performed only between said times t1 and t2 from the second iteration onwards.

9. A method as claimed in any one of claims 7 to 8, wherein an optimum number of wellbores to be drilled and the order in which said wellbores are to be drilled between said times t1 and t2 are determined.

10. A method as claimed in claim 9, wherein said optimum number of wellbores to be drilled and said order in which said wellbores are to be drilled are determined from the analysis of the oil production evolution over time resulting from the addition of at least one new wellbore.

11. A method as claimed in any one of the previous claims, wherein said new wellbore is an injection well or a production well, straight or deflected, perforated over the entire height of the well or partly.

12. A method as claimed in any one of the previous claims, wherein uncertainties are taken into account for determining the location of said new wellbore.

13. A method as claimed in any one of the previous claims, wherein said classification method is the K-means algorithm.

14. A method as claimed in any one of the previous claims, wherein said reservoir simulation is performed between said time t1 and said time t2 by taking account of multiplicative coefficients applied to productivity indices of said first wellbores traversing said formation.

15. A method as claimed in any one of claims 1 to 14, wherein development drilling is performed at said determined locations.

16. A computer program product downloadable from a communication network and/or recorded on a computer-readable medium and/or processor executable, comprising program code instructions for implementing the method as claimed in any one of claims 1 to 14, when said program is executed on a computer.
